# EUROPEAN PATENT APPLICATION

(11) **EP 1 293 297 A1**
(43) Date of publication of application: **19.03.2003**
(21) Application number: 01938730.7
(22) Date of filing: 18.06.2001
(51) Int. Cl.: B24B 37/04, H01L 21/304

(54) **POLISHING PAD**

(30) Priority: 19.06.2000 JP 2000183846
(71) Applicant: RODEL NITTA COMPANY, Osaka-shi, Osaka 556-0022 (JP)
(72) Inventor: KOMUKAI, Takuji, c/o RODEL NITTA COMPANY Mie Facto, Inabe-gun, Mie 511-0200 (JP); IMAHARA, Yasutaka,c/o RODEL NITTA COMPANY Mie Fact, Inabe-gun, Mie 511-0200 (JP); OSAKI, Kouichi,c/o RODEL NITTA COMPANY Mie Factory, Inabe-gun, Mie 511-0200 (JP)
(74) Representative: Tanner, James Percival
(86) International application number: JP0105192
(87) International publication number: WO01098028

(57) **Abstract**

A polishing pad includes a pad body; and a transparent window integrally formed in the pad body. The window is formed of a material which is more susceptible to abrasion than a material of the pad body. The pad body has a plurality of grooves formed in a surface thereof, and the window has no grooves in a surface thereof. A surface of the window is recessed with respect to a surface of the pad . The polishing pad prevents a slurry from settling on the window so as to improve the detection precision of the polishing rate. Furthermore, the polishing pad prevents the window from gradually projecting with respect to the pad body by dressing during polishing so as to substantially eliminate adverse effect on the polishing characteristic.

## Description

### TECHNICAL FIELD

The present invention relates to a polishing pad used for polishing a semiconductor device or other electronic components. Specifically, the present invention relates to a polishing pad used in a polishing apparatus adopting a CMP (chemical mechanical polishing) technology, the polishing pad having a transparent window through which laser light or visible light is transmitted, in order to allow a polishing rate of a wafer (i.e., the amount of wafer removed by polishing) to be measured while polishing the wafer.

### BACKGROUND ART

A semiconductor multiple layer IC is preferably smoothed at the semiconductor wafer stage during the production thereof.

A semiconductor wafer is usually smoothed by a CMP polishing apparatus adopting a CMP technology. The CMP polishing apparatus includes a lower board having a circular rotatable plate on which a polishing pad is mounted, an upper board for pressing a semiconductor wafer to the polishing pad, and a section for supplying a slurry to the polishing pad.

Using such a CMP polishing apparatus, a polishing rate of the wafer is measured while the wafer is polished. Since the polishing rate is measured by irradiating a surface of the wafer to be polished with laser light from a rear surface of the polishing pad, the polishing pad needs to have a transparent window for allowing the laser light to be transmitted through the polishing pad. The rear surface of the polishing pad faces the lower board.

A conventional polishing pad includes a pad body and a foam layer stacked on the pad body with a pressure-sensitive adhesive layer interposed therebetween. The pad body has an opening at a prescribed position thereof, and a window formed of a transparent resin is fit in the opening.

Conventionally, the window is provided by the following method.

(1) The pad body is punched out to form a hole, and a transparent plate is fit in the hole as a window.

However, this method has the following problems.
(i) A gap is made between the pad body and the window, and a slurry flows into the gap so as to cloud the window, which prevents the laser light from being clearly transmitted. This is fatal to the measurement of the polishing rate.
(ii) The window is deformed, for example, warped, which may cause malfunction.
(iii) A thickness of the window is set with respect to the thickness of the pad body. Since the thickness of the window is provided with a tolerance, the thickness of the window can be equal to the thickness of the pad body. In this case, the window may project out of the pad body depending on the manner of setting the window.
(iv) The window, which is bonded to the foam layer with a two-sided adhesive tape provided along only 3.0 to 4.0 mm-long portions along the circumference of the window, is easily peeled off.

In order to solve these problems, the following method of forming a window is proposed.

(2) Before forming the pad body, a transparent resin plate which will become a window is secured at a prescribed position in a mold. Then, a resin for forming the pad body injected into the mold, thus forming a resin cake. By slicing the resin cake, a pad sheet integrally including the pad body and the window is produced. There is no gap between the pad body and the window.

This production method solves the problems of (i), (ii) and (iv) described above.

However, the polishing pad produced by this method has the following problems.
(i) In general, fine grooves are formed in the entire surface of the pad body in order to satisfactorily disperse the slurry. The method (2) inevitably forms the grooves in the window as well as the pad body. This causes the slurry to be in the grooves in the window, and thus attenuates the intensity of the transmitted light when an object to be detected (e.g., a wafer) is formed of certain materials.
(ii) When newly produced, the pad body and the window are on the same plane. Since the material of the window generally has a higher density and thus less susceptible to abrasion than the material of the pad body, the window gradually projects from the pad body as the polishing pad is more and more used for polishing the wafers. As a result, dressing during polishing may undesirably scratch the window, which causes light transmission noise, i.e., clouds the window and attenuates the intensity of transmitted light.

The present invention has an objective of providing a polishing pad for preventing a slurry from settling in a groove of a window and thus raising the detection precision of the polishing rate.

The present invention has another objective of providing a polishing pad for preventing a window from gradually projecting from a pad body as a result of dressing during polishing and thus improving the polishing characteristic.

### DISCLOSURE OF THE INVENTION

According to one aspect of the invention, a polishing pad includes a pad body; and a transparent window integrally formed in the pad body. The window is formed of a material which is more susceptible to abrasion than a material of the pad body.

According to another aspect of the invention, a polishing pad includes a pad body; and a transparent window integrally formed in the pad body. The pad body has a plurality of grooves formed in a surface thereof, and the window has no grooves in a surface thereof.

According to still another aspect of the invention, a polishing pad includes a pad body; and a transparent window integrally formed in the pad body. A surface of the window is recessed with respect to a surface of the pad body.

In one embodiment of the invention, the pad body has a plurality of grooves formed in a surface thereof, and the window has no grooves in a surface thereof.

In one embodiment of the invention, the pad body and the window are integrally formed as a result of placing one of the window and a resin block forming the window in a mold and then injecting a resin forming the pad body into the mold.

In one embodiment of the invention, the window and the resin block are each formed of a transparent resin containing a urethane resin.

### BRIEF DESCRIPTION OF THE DRAWINGS

Figure **1** is a cross-sectional view of a polishing pad in an embodiment according to the present invention;
Figure **2** is a plan view of the polishing pad shown in Figure **1;**
Figure **3** is an enlarged plan view of a window of the polishing pad shown in Figure **1**;
Figure **4A** is a cross-sectional view of a board on which the polishing pad according to the present invention is mountable;
Figure **4B** is a plan view of the board shown in Figure **4A;**
Figure **5A** is a cross-sectional view of the board on which the polishing pad according to the present invention is mountable;
Figure **5B** is a plan view of the board shown in Figure **5A;**
Figure **6A** is an enlarged plan view of the board shown in Figures **4A, 4B, 5A** and **5B,** showing a portion corresponding to a window of the polishing pad;
Figure **6B** is an enlarged cross-sectional view of the portion of the board shown in Figure **6A;**
Figure **7** shows an recess of the portion of the board shown in Figures **6A** and **6B;**
Figure **8** shows a jig usable for a polishing pad according to the present invention;
Figure **9** shows an opening of the jig shown in Figure **8;**
Figure **10** is a graph illustrating the susceptibility to abrasion of a polishing pad according to the present invention;
Figure **11** is a graph illustrating the susceptibility to abrasion of a conventional polishing pad;
Figure **12** is a cross-sectional view of a polishing pad in a second embodiment according to the present invention; and
Figure **13** is a cross-sectional view of a polishing pad in a third embodiment according to the present invention.

### BEST MODE FOR CARRYING OUT THE INVENTION

Hereinafter, the present invention will be described by way of illustrative embodiments with reference to the accompanying drawings.

### (Embodiment 1)

A polishing pad **100** according to a first embodiment of the present invention will be described.

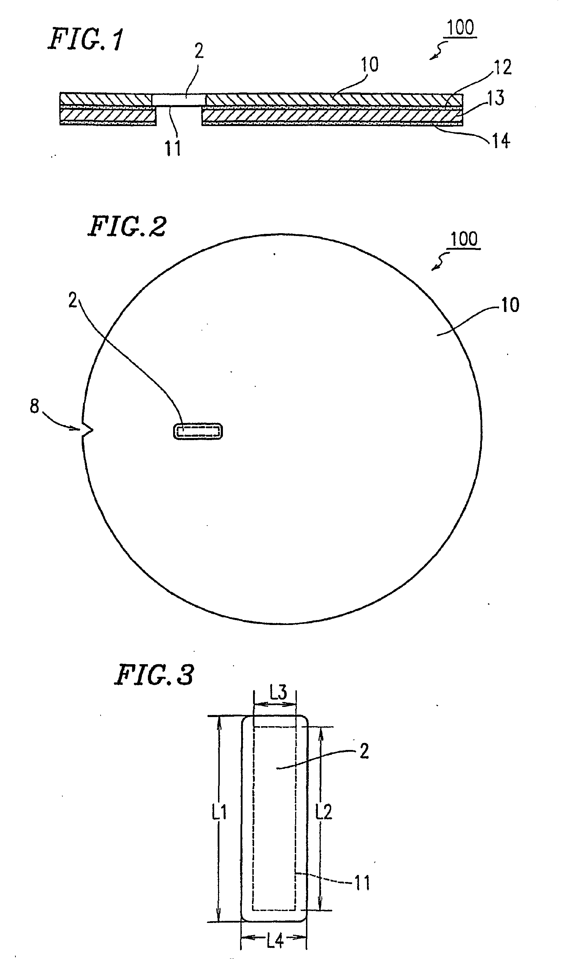

As shown in Figures **1** and **2,** the polishing pad **100** includes a pad body **10** and a window **2** formed in the pad body **10.** The pad body **10** is generally formed of a resin layer having fine air holes.

The polishing pad **100** further includes a pressure-sensitive adhesive layer **12** provided on a lower surface of the pad body **10,** a base layer **13** formed of a foaming material and provided on the pressure-sensitive adhesive layer **12**, a pressure-sensitive adhesive layer **14** provided on the base layer **13,** and a release sheet (not shown) provided on the pressure-sensitive adhesive layer **14**. For using the polishing pad **100**, the release sheet is peeled off and the pressure-sensitive adhesive layer **14** is bonded to a lower board of a polishing apparatus (not shown).

In Figure **2,** reference numeral **8** represents a V-shaped cutout used for peeling off the polishing pad **100** from the lower board.

The pad body **10** can be formed of, for example, a urethane resin, an acrylic resin, polycarbonate, polyamide, and polyester. These materials can be used independently, or a combination of two or more of these materials can be used. The pad body **10** can be formed of, for example, an thermoplastic resin by an injection molding method or an extrusion molding method. Alternatively, the pad body **10** can be formed of a thermosetting resin by a heating and curing method.

The molded resin body is sliced to produce a pad sheet. More specifically, a block of a transparent material for forming the window **2** is placed in a mold, and a non-transparent material for forming the pad body **10** is injected into the mold, thereby forming the molded resin body. By slicing the molded resin body, a pad sheet is produced. On the pad sheet, the pressure-sensitive adhesive layer **12**, the base layer **13**, the pressure-sensitive adhesive layer **14,** and the release sheet are sequentially provided, thereby producing the polishing pad **100.** The base layer **13** has an opening **11** at a position corresponding to the position of the window **2**.

Instead of the block of the transparent material for forming the window **2,** the window **2** can be placed in the mold.

The polishing pad **100** produced in this method has the pad body **10** and the window **2** in an integrated state and does not have the problem of the gap between the pad body **10** and the window **2** or the problem of the window **2** projecting from the pad body **10**.

The pad body **10** has a plurality of fine grooves in a surface thereof. The shape, size and pattern of the grooves can be changed in accordance with the purpose of use of the polishing pad **100.** The grooves can be, for example, concentric.

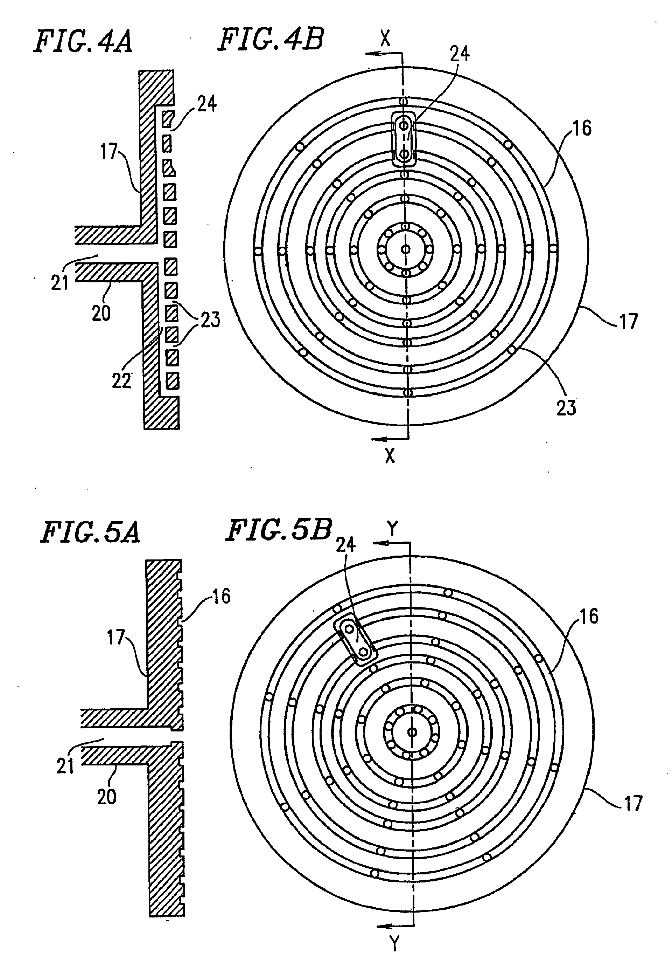

The window **2** is, for example, a transparent resin such as, for example, polyvinyl chloride, polyvinylidene fluoride, polyethersulfone, polystyrene, polyethylene, polytetrafluoroethylene or any of the above-listed materials usable for the pad body **10.** The block of the material for forming the window **2** is produced by injection-molding or extrusion-molding one of these materials and cutting the molded resin into a desired size and thickness. Figure **3** shows an example of the window **2**. In Figure **3,** L1 is about 57 mm, L2 is about 50 mm, L3 is about 12 mm, and L4 is about 14 mm.

The material of the window **2** is more susceptible to abrasion than the material of the body pad **10**, so that the window **2** is always recessed with respect to the pad body **10**. Thus, the problem that the window **2** is gradually projected from the pad body **10** as the polishing pad is more and more used is overcome so as to prevent adversely influencing the polishing characteristic.

The material of the window **2** can be made more susceptible to abrasion than the material of the pad **10** by, for example, changing the mixing ratios of a main component and a curing agent when the block of the material of the window **2** (for example, urethane) is polymerized from a urethane prepolymer. For example, the mixing ratio can be 110% with respect to the usual amount for the main component containing urethane prepolymer and 100% with respect to the usual amount for the curing agent. In this case, the material can be cured at a high temperature of 100°C or higher.

### (Embodiment 2)

A polishing pad **200** according to a second embodiment of the present invention will be described. Identical elements previously discussed with respect to Figure **1** bear identical reference numerals and the detailed descriptions thereof will be omitted.

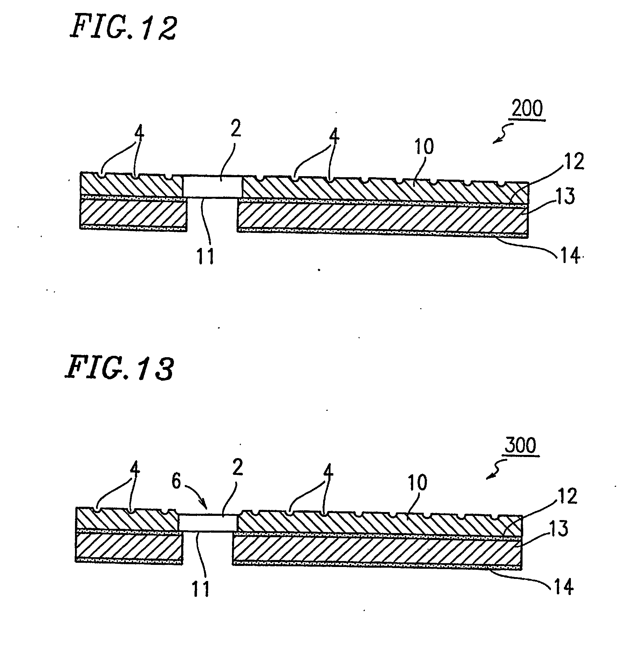

As shown in Figure **12**, the polishing pad **200** includes a pad body **10** and a window **2** integrally formed in the pad body **10.**

The pad body **10** has a plurality of fine grooves **4** in a surface thereof. The shape, size and pattern of the grooves can be changed in accordance with the purpose of use of the polishing pad **200**. Each groove **4** can be, for example, ring-shaped, and the plurality of fine grooves **4** can be, for example, concentric. The window **2** has no grooves on a surface thereof.

As in the first embodiment, the polishing pad **200** further includes a pressure-sensitive adhesive layer **12** provided on a lower surface of the pad body **10,** a base layer **13** formed of a foaming material and provided on the pressure-sensitive adhesive layer **12,** a pressure-sensitive adhesive layer **14** provided on the base layer **13,** and a release sheet (not shown) provided on the pressure-sensitive adhesive layer **14**. For using the polishing pad **200**, the release sheet is peeled off and the pressure-sensitive adhesive layer **14** is bonded to a lower board of a polishing apparatus (not shown).

The pad body **10** and the window **2** are formed of the same materials as those in the first embodiment. Preventing the grooves from being formed in the surface of the window **2** solves the problem of a slurry settling in the grooves causing light transmission noise, i.e., clouds the window and attenuates the intensity of transmitted light.

The polishing pad **200** is produced as follows.

Figures **4B** and **5B** are plan views of a board **17** of a curved groove forming machine. Figure **4A** is a cross-sectional view of the board **17** taken along lines **X-X** in Figure **4B,** and Figure **5A** is a cross-sectional view of the board **17** taken along lines **Y-Y** in Figure **5B.**

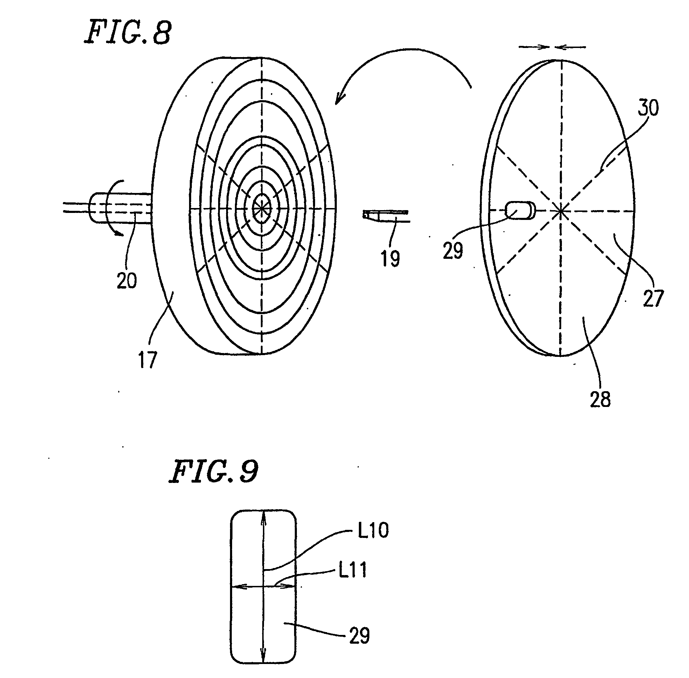

A pad sheet is secured on the board **17** by a suction force. The grooves **4** are formed by pressing a cutter knife **19** (Figure **8**) to a surface of the pad sheet while rotating the board **17**.

A rotation shaft **20** for rotating the board **17** has a suction hole **21** formed therein which is connected to a suction apparatus (not shown). The board **17** has a suction path **22** formed therein and a plurality of suction openings **23** formed at a surface of the board **17**. The suction openings **23** are communicated to the suction hole **21** through the suction path **22.** In Figures **4B** and **5B,** reference numeral **16** represents a ring groove formed at the surface of the board **17.**

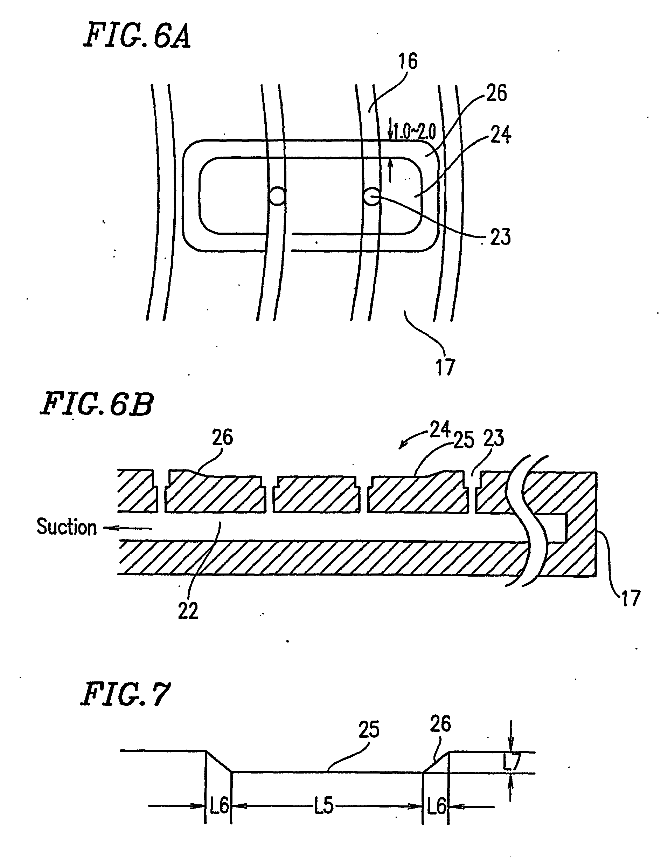

The board **17** has a recess **24** at a position corresponding to the position of the window **2.** As shown in Figures **6A, 6B** and **7,** the recess **24** has a flat portion **25** slightly recessed from the surface of the rest of the board **17** and a tapered portion **26** tapering from the flat portion **25** to the surface of the rest of the board **17**. The plurality of openings **23** described above are also formed in the flat portion **25**.

The flat portion **25** preferably has a width and a length which are respectively equal to or greater than the width and the length of the window **2**. Referring to Figure **7**, L5 (width of the flat portion **25**) is, for example, preferably about 5 to 10 mm greater, and is more preferably about 4 mm greater than the width (L4 in Figure **3**) of the window **2**. The width of the tapered portion **26** (L6) is preferably about 1.0 to 2.0 mm, and the depth of tapered portion **26** (L7) is preferably about 500 µm or more, more preferably about 500 to 600 µm. The inner pressure of the suction hole **21** when the pad sheet is absorbed toward surface of the board **17** at the maximum is preferably 0 to 250 torr.

When the pad sheet is secured by a suction force on the board **17**, the window **2** is recessed along the topology of the surface of the board **17**. Accordingly, the cutting knife **19** reaches the pad body **10** on the board **17** so as to form the grooves, but does not reach the window **2**. Thus, the grooves are not formed in the window **2**.

Figure **8** shows a jig **27** for preventing the grooves from being formed in the window **2**. The jig **27** is usable instead of forming the recess **24** as described above.

The jig **27** is formed of a metal plate or a resin plate having a thickness of about 0.5 mm and having an opening **29** at a position corresponding to the position of the window **2.** The opening **29** preferably has a width (L11 in Figure **9**) and a length (L10) which are respectively equal to or greater than the width and the length of the window **2** by, for example, about 6 to 8 mm. The jig **27** has a plurality of through-holes **30.**

The jig **27** is placed on the board **17,** and window **2** of the pad sheet which is placed on the jig **27** is recessed due to the suction force. Thus, the cutting knife **9** does not reach the window **2** and the grooves are prevented from being formed on the window **2**.

### (Embodiment 3)

A polishing pad **300** according to a third embodiment of the present invention will be described. Identical elements previously discussed with respect to Figure **1** bear identical reference numerals and the detailed descriptions thereof will be omitted.

As shown in Figure **13**, the polishing pad **300** includes a pad body **10** and a window **2** integrally formed in the pad body **10**.

The window **2** is recessed (indicated with a recessed portion **6**) with respect to the pad body **10,** and the pad body **10** has a plurality of fine grooves **4** in a surface thereof. The shape, size and pattern of the grooves can be changed in accordance with the purpose of use of the polishing pad **300**. Each groove **4** can be, for example, ring-shaped, and the plurality of fine grooves **4** can be, for example, concentric. The window **2** has no grooves on a surface thereof.

As in the first embodiment, the polishing pad **300** further includes a pressure-sensitive adhesive layer **12** provided on a lower surface of the pad body **10,** a base layer **13** formed of a foaming material and provided on the pressure-sensitive adhesive layer **12,** a pressure-sensitive adhesive layer **14** provided on the base layer **13,** and a release sheet (not shown) provided on the pressure-sensitive adhesive layer **14**. For using the polishing pad **300**, the release sheet is peeled off and the pressure-sensitive adhesive layer **14** is bonded to a lower board of a polishing apparatus (not shown).

The conventional polishing pad has a pad body and a window on the same plane. Therefore, the window gradually projects from the pad body as the polishing pad is more and more used for polishing the wafers. As a result, dressing during polishing may undesirably scratch the window, which causes light transmission noise, i.e., clouds the window and attenuates the intensity of transmitted light. The polishing pad **300** is effective for preventing such scratches.

Since the window **2** is recessed with respect to the pad body **10**, the window **2** does not have grooves in a surface thereof even when the pad body **10** has grooves **4** in a surface thereof. Therefore, the light transmission noise caused by the slurry settling in the grooves **4** can be prevented.

Since the window **2** is recessed with respect to the pad body **10**, the window **2** does not need to be formed of a material sufficiently susceptible to abrasion. Therefore, the window **2** can be formed of a variety of material. For example, the material of the window **2** can be selected from the viewpoint of transparency.

Since the window **2** is recessed with respect to the pad body **10**, a gap is made between the window **2** and a wafer. Thus, the smooth dispersion of the slurry while the polishing operation is promoted. This also prevents scratches of wafer surfaces.

The polishing pad **300** is produced as follows.

After the pad sheet including the pad body **10** and the window **2** is produced, the window **2** is gouged to form the recessed portion **6.** The recessed portion **6** preferably has a depth of about 400 to 500 µm. The recessed portion **6** preferably has a width and a length which are respectively greater than the width and the length of the window **2** by about 5 to 10 mm.

Among the above-listed substances usable for a polishing pad according to the present invention, a polyurethane composition is preferable. A preferable method for producing the polishing pad is a prepolymer method or a one shot method.

According to a prepolymer method, first, a polyol component and an isocyanate component are reacted with each other to form a urethane prepolymer. Then, the resultant urethane prepolymer, a diamine or a diol, a foaming agent and a catalyst are mixed to form a urethane composition. The urethane composition is cured.

According to a one shot method, a polyol component, an isocyanate component, a diamine or a diol, a foaming agent and a catalyst are mixed to form a urethane composition. The urethane composition is cured.

Examples of usable urethane prepolymer include polyether-based urethane prepolymer, polyester-based urethane prepolymer, and polyesterether-based urethane prepolymer.

### (Example)

Hereinafter, a specific example of the present invention will be described.

A composition for the window **2** was prepared by mixing 3297 g of a polyether-based urethane prepolymer (Uniroyal Adiprene L-325 available from Uniroyal Chemical) and 824 g of a curing agent (MOCA; 3,3'-dichloro-4,4'-diaminodiphenylmethane).

The composition was injected into a mold and left at about 150°F for 15 minutes. Thus, a block of the composition for the window **2** was produced.

A composition for the pad body **10** was prepared by mixing 3297 g of a polyether-based urethane prepolymer (Uniroyal Adiprene L-325 available from Uniroyal Chemical) and 749 g of a curing agent (MOCA; 3,3'-dichloro-4,4'-diaminodiphenylmethane).

The block of the composition for the window **2** was placed in a mold and the composition for the pad body **10** was injected into the mold. The block and the composition for the pad body **10** were left at about 150°F for 15 minutes. The obtained molded body was sliced into a prescribed thickness, thereby producing a pad sheet.

The produced pad sheet was measured for the susceptibility to abrasion by a polishing machine (Strasbaugh•6CA; diameter of the board: 20 inches). The polishing was performed at a seasoning pressure of 0.1 kgf/cm², a rotation rate of a lower board of 89 rpm, a rotation rate of the carrier for holding the wafer mounted on an upper board of 60 rpm, and a supply of pure water of 3,000 cm³/min. As the seasoning tool, R#80 (Kabushiki Kaisha Fujimori Gijutsu Kenkyuusho) was used.

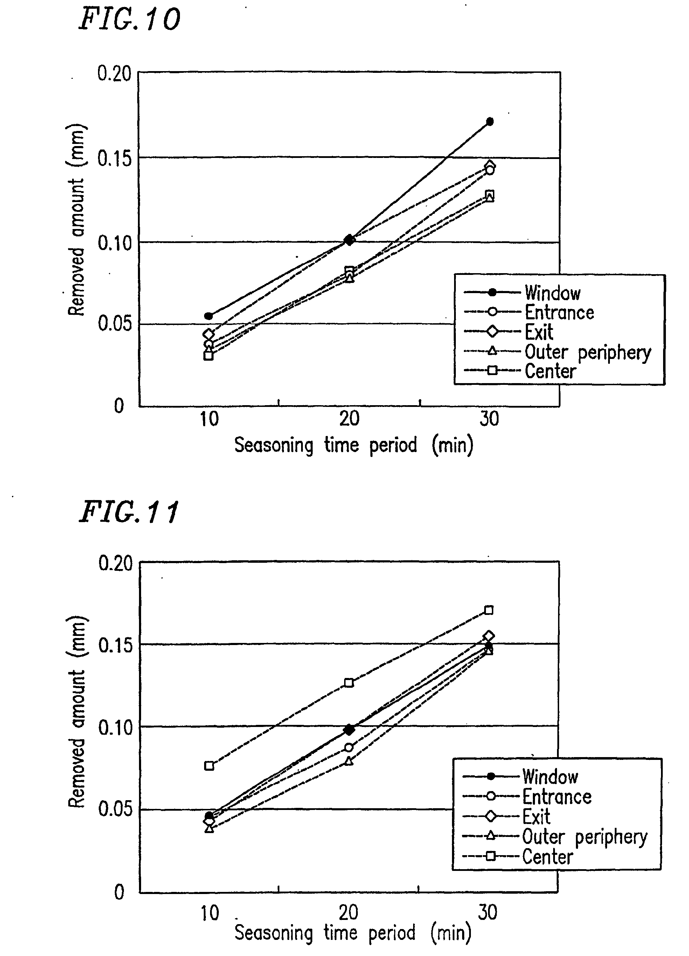

The results are shown in Figure **10**. Figure **10** shows the relationship between the final removed amount of the polished pad and the seasoning time period. In Figure **10,** the "entrance" indicates an area of the polishing pad **100** (Figure **2**) which is to the left of an imaginary line extending from the window **2** to the V-shaped cutout **8.** The "exit" indicates an area of the polishing pad **100** (Figure **2**) which is to the right of an imaginary line extending from the window **2** to the V-shaped cutout **8**. As the lower board is rotated, the polishing pad is polished by a seasoning tool always in the order from the entrance to the window **2** and then to the exit. The "outer periphery" indicates an outer circumferential edge of the polishing pad **100,** and the "center" indicates a central area of the polishing pad **100.**

### (Comparative example)

A polishing pad was produced in the same manner as in the Example except that the window **2** was formed of the composition used for forming the pad body **10.**

The resultant pad sheet was measured for the susceptibility to abrasion in the same manner as in the Example. The results are shown in Figure **11**.

In the case of the pad sheet obtained in the Example (Figure **10**), as the polishing proceeds, the removed amount of the window **2** increases with respect to the removed amount of the pad body **10**. In the case of the pad sheet obtained in the comparative example (Figure **11**), the removed amount of the window **2** and the removed amount of the pad body **10** are approximately the same even as the polishing proceeds.

A polishing pad produced using the pad sheet obtained in the Example and a polishing pad produced using the pad sheet obtained in the comparative example were used for polishing wafers under the conditions used for polishing silicon wafers with a conventional polishing pad.

The grooves made in the window **2** caused noise in the case of the polishing pad produced using the pad sheet obtained in the comparative example, but not in the case of the polishing pad produced using the pad sheet obtained in the Example.

### INDUSTRIAL APPLICABILITY

The present invention provides a polishing pad for preventing a slurry from settling in a groove of a window and thus raising the detection precision of the polishing rate, and for preventing a window from gradually projecting from a pad body as a result of dressing during polishing and thus improving the polishing characteristic.

## Claims

1. A polishing pad, comprising:
a pad body; and
a transparent window integrally formed in the pad body,
wherein the window is formed of a material which is more susceptible to abrasion than a material of the pad body.

2. A polishing pad, comprising:
a pad body; and
a transparent window integrally formed in the pad body,
wherein the pad body has a plurality of grooves formed in a surface thereof, and the window has no grooves in a surface thereof.

3. A polishing pad, comprising:
a pad body; and
a transparent window integrally formed in the pad body,
wherein a surface of the window is recessed with respect to a surface of the pad body.

4. A polishing pad according to claim 3, wherein the pad body has a plurality of grooves formed in a surface thereof, and the window has no grooves in a surface thereof.

5. A polishing pad according to claim 1, wherein the pad body and the window are integrally formed as a result of placing one of the window and a resin block forming the window in a mold and then injecting a resin forming the pad body into the mold.

6. A polishing pad according to claim 5, wherein the window and the resin block are each formed of a transparent resin containing a urethane resin.

7. A polishing pad according to claim 2, wherein the pad body and the window are integrally formed as a result of placing one of the window and a resin block forming the window in a mold and then injecting a resin forming the pad body into the mold.

8. A polishing pad according to claim 7, wherein the window and the resin block are each formed of a transparent resin containing a urethane resin.

9. A polishing pad according to claim 3, wherein the pad body and the window are integrally formed as a result of placing one of the window and a resin block forming the window in a mold and then injecting a resin forming the pad body into the mold.

10. A polishing pad according to claim 9, wherein the window and the resin block are each formed of a transparent resin containing a urethane resin.
